# EUROPEAN PATENT SPECIFICATION

(11) **EP 0 365 857 B1**
(45) Date of publication and mention of the grant of the patent: **04.01.1995**
(21) Application number: 89117869.1
(22) Date of filing: 27.09.1989
(51) Int. Cl.: H01L 29/812, H01L 29/10

(54) **Semiconductor device including a MESFET**
MESFET enthaltende Halbleiteranordnung
Dispositif semi-conducteur comportant un MESFET

(30) Priority: 29.09.1988 JP 245138/88; 29.09.1988 JP 245139/88; 29.09.1988 JP 245140/88; 30.09.1988 JP 246631/88
(43) Date of publication of application: 02.05.1990
(73) Proprietor: SUMITOMO ELECTRIC INDUSTRIES, LTD., Osaka-shi, Osaka 541 (JP)
(72) Inventor: Nishiguchi, Masanori Yokohama Works of Sumitomo, Yokohama-shi Kanagawa (JP); Okazaki, Naoto, Uyko-ku Kyoto (JP)
(74) Representative: Kahler, Kurt, Dipl.-Ing.

(56) References cited:
- EP-A- 0 303 248
- I.E.E.E. ELECTRON DEVICE LETTERS, vol. EDL-8, no. 3, March 1987, pages 118-120;ZEGHBROECK et al.: "Submicrometer GaAs MESFET with shallow channel and very high transconductance"

## Description

### (Background of the Invention)

This invention relates to a semiconductor device using a GaAs metal semiconductor field effect transistor (MESFET), specifically to that which can be used in machines and instruments requiring radiation tolerance, radiation hardness or radiation resistance.

### (Related Background Art)

The devices which are used in aerospace systems and near nuclear reactors required high radiation hardness. The radiation includes gamma (γ) rays, neutron rays, proton rays, etc. Generally, the gallium arsenide (GaAs) MESFETs and ICs based upon these FETs will withstand total exposure dose of 1×10⁸ roentgens with little if any change in characteristics. By contrast, silicon (Si) MOS circuits have failed at dose of 1×10⁶ roentgens (Proceedings of Symposium of Space Development, 1987, ps. 35 ∼ 38).

For improving the radiation hardness of the GaAs MESFET, the following art has been proposed. In a first one, a p-type layer is buried below an n-type active layer to thereby decrease leakage current to the substrate, and the threshold voltage of a GaAs FET is improving in the radiation hardness. In a second one, the Schottky gate of a GaAs FET is shortened.

But these prior art have improved the radiation hardness up to a total exposure dose R of about 1 x 10⁸ roentgens, but it cannot be said that these prior art have succeeded in attaining the sufficiently practical level (1 x 10⁹ roentgens). Under these circumstances, no practical transistor having a radiation resistance of about 1 x 10⁹ roentgens has been realized yet.

Thus, an object of this invention is to provide a GaAs MESFET which has a simple structure and a high radiation hardness which has been improved by especially making use of changes of at least one of the threshold voltage, the saturated drain current, and the transconductance.

IEEE, EDL-8, no. 3 pp. 118 - 120 discloses scaled submicrometer GaAs MESFET's having very high transconductance and being optimized for their K-value important to logic applications. These GaAs MESFET's have recessed gate structures and a buried layer. Furthermore, the channel layer is characterized by a channel doping of 9 x 10¹⁷ cm⁻³ and a channel thickness of 750 Å (10⁻¹⁰ m).

### Summary of the Invention

The inventors have noticed that when radiation is applied to a GaAs MESFET, the change amount ΔVₜₕ of the threshold voltage Vₜₕ in the saturation region, the change rate α = I_{dssA} /I_{dss} of saturated drain current at normal gate bias I_{dss}, and the change rate β = g_{mA}/gₘ of a transconductance gₘ has a constant relationship with the effective thickness tₐ of the active layer and the change amount ΔN_{D} of the carrier concentration N_{D}, and has found that the change amount ΔN_{D} has a constant quantitative relationship with the total exposure dose R. Based on this finding, they have completed this invention as defined in claim 1.

In this arrangement, under irradiation of a total exposure dose even above 1x10⁹ roentgens, at least any one of the threshold voltage Vₜₕ, the saturated drain current I_{dss}, and the transconductance gₘ are within their corresponding preset ranges (tolerable ranges determined by the signal processing circuit). Consequently, the semiconductor device according to this invention comprising the GaAs MESFET and a signal processing circuit can operate normally as initially designed.

The present invention will become more fully understood from the detailed description given hereinbelow and the accompanying drawings which are given by way of illustration only, and thus are not to be considered as limiting the present invention.

Further scope of applicability of the present invention will become apparent from the detailed description given hereinafter.

### BRIEF DESCRIPTION OF THE DRAWINGS

Fig. 1 is a sectional view of a GaAs MESFET explaining the principle of this invention;
Fig. 2 is a graph showing the total exposure dose R dependence of a change amount ΔVₜₕ of the threshold voltage of the MESFET involved in this invention;
Fig. 3 is a graph showing the total exposure dose R dependence of a decrease amount ΔN_{D} of the carrier concentration;
Fig. 4 is a graph showing the result of the experiment on the total exposure dose R dependence of a change amount ΔVₜₕ of the threshold voltage of a conventional MESFET;
Fig. 5 is a graph showing the total exposure dose R dependence of a change rate α of the saturated drain current of the MESFET involved in this invention;
Fig. 6 is a graph showing the total exposure dose R dependence of a change of the saturated drain current I_{dss};
Fig. 7 is a graph showing the total exposure dose R dependence of a change rate β of the transconductance of the MESFET involved in this invention;
Fig. 8 is a graph showing the results of the experiments on the total exposure dose R dependence of a change of the transconductance gₘ of the conventional MESFET; and
Figs. 9 to 11 are characteristic curves of the threshold voltage, saturated drain current, and transconductance of the MESFET involved in this invention and of the conventional FETs for comparison in radiation hardness.

### DESCRIPTION OF THE PREFERRED EMBODIMENT

This invention will be explained in good detail with reference to the drawings showing the principle and structure of this invention.

The semiconductor device according to this invention comprises a GaAs MESFET, and a signal processing circuit cooperatively combined with the MESFET. The MESFET and the signal processing circuit can provide combination circuits, e.g., amplifiers, inverters, oscillaters, digital logic arrays, etc. The MESFET in this combination circuit involved in this invention has a preset threshold voltage Vₜₕ, a saturated drain current at normal gate bias I_{dss}, and a transconductance gₘ in the saturation region. It has been known that their values change under radiation exposure. When a changed threshold voltage V_{thA}, a changed saturated drain current I_{dssA}, and a changed transconductance g_{mA} of which their initial values have changed due to radiation exposure are out of their preset ranges by the signal processing circuit, this combination circuit does not normally operate. Hereinafter in this specification, a tolerable value of a change amount ΔVₜₕ of the threshold voltage Vₜₕ is represented by a tolerable change amount ΔV_{thL}. A tolerable value of a change rate α=I_{dssA} /I_{dss} of the saturated drain current I_{dss} is represented by a tolerable change rate α_{L}, and a tolerable value of a change rate β=g_{mA} /gₘ of the transconductance is represented by a tolerable change rate β_{L}. The values of ΔV_{thL}, α_{L} and β_{L} vary depending on designs of the above described signal processing circuit, but generally are ΔV_{thL} equal to or lower than 0.2 V, and α_{L} and β_{L} equal to or higher than 0.8.

As described above, it is known that the threshold voltage Vₜₕ, etc. change under radiation exposure. As causes for these changes have been reported, firstly, decreases in a carrier concentration of the active layer due to radiation exposure, and secondly decreases in an electron mobility therein due to radiation exposure. The inventors discussed the first cause in good detail and found the relationship${\text{ΔN}}_{\text{D}} {\text{= b·R}}^{\text{c}}$
where b and c are constants,holds between a decrease amount of a carrier concentration N_{D} and a total exposure dose R. Formula 1 holds when an initial carrier concentration N_{D} (before radiation exposure) of the active layer is 1×10¹⁷ ∼ 1×10¹⁹cm⁻³, a total dose R of exposure radiation is 1×10⁸ ∼ 1×10¹⁰ roentgens. The constants b and c have some ranges depending on changes of an initial carrier concentration of the active layer, qualities of the substrates, etc. According to the experiments conducted by the inventors, the constants b and c have ranges of$\text{1.99 × 10¹⁰ ≦ b ≦ 3.98 × 10¹⁰} \text{0.5 ≦ c ≦ 0.8}$
and the typical values are b=3.06×10¹⁰ , c=0.678. Therefore, the typical value of the decrease amounts ΔN_{D} of the carrier concentration is defined by${\text{ΔN}}_{\text{D}} {\text{= 3.06 × 10¹⁰ · R}}^{\text{0.678}} \text{.}$

The experiment in which the relationship of Formula 1 was found will be explained below in good detail.

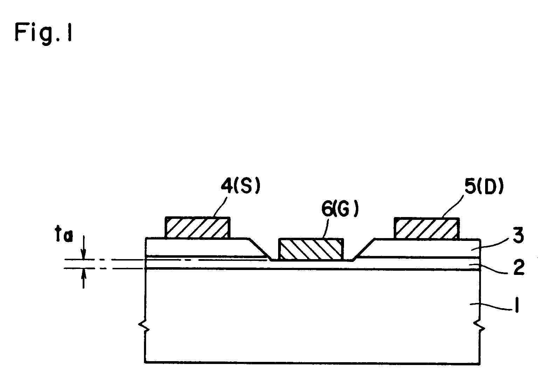

Fig. 1 shows a sectional view of a GaAs MESFET having a recess gate structure. As shown in Fig. 1, an n-type active layer 2, and an n⁺ doped contact region 3 are formed on a semi-insulating GaAs substrate 1. Parts of the n-type active layer 2 and the n⁺ doped contact region 3 for a gate region to be provided are etched off to form a recess structure. Then a source electrode 4 and a drain electrode 5 of ohmic metal are formed on the n⁺ doped contact region 3 by the vacuum evaporation. A gate electrode 6 of Schottky metal is formed on the n-type active layer 2. The part of the n-type active layer 2 directly below the gate electrode 6 has a sufficiently smaller thickness, an effective thickness of about 500 Å, compared with the n-type active layers of the conventional MESFETs (each having a thickness of about 1000 Å), and the active layer 2 has a higher carrier concentration N_{D}, specifically 1×10¹⁸cm⁻³, compared with the carrier concentrations of the conventional MESFETs.

The theoretical value of the threshold voltage Vₜₕ of this GaAs MESFET is given by${\text{V}}_{\text{th}} {\text{= V}}_{\text{bi}} {\text{- (q·N}}_{\text{D}} {\text{·t}}_{\text{a}} \text{²)/2ε}$
S. Sze, "Physics of Semiconductor Devices," 2nd ed. John Wiley and Sons, 1981, ps. 312 ∼361. In Formula 2, V_{bi} represents a built-in voltage of the MESFET; q, an electron charge; and ε , a dielectric constant of the n-type active layer 2. When the carrier concentration N_{D} of the n-type active layer 2 becomes N_{DA} due to radiation exposure, a changed threshold voltage V_{thA} after the radiation exposure is given by${\text{V}}_{\text{thA}} {\text{= V}}_{\text{bi}} {\text{- (q·N}}_{\text{DA}} {\text{·t}}_{\text{a}} \text{²)/2ε}$
A change amount ΔVₜₕ of the threshold voltage Vₜₕ due to the radiation exposure is given by${\text{ΔV}}_{\text{th}} {\text{= V}}_{\text{thA}} {\text{- V}}_{\text{th}} {\text{= {V}}_{\text{bi}} {\text{-(q·N}}_{\text{DA}} {\text{·t}}_{\text{a}} {\text{²)/2ε} - {V}}_{\text{bi}} {\text{-(q·N}}_{\text{D}} {\text{·t}}_{\text{a}} \text{²)/2ε}} {\text{= {(q·t}}_{\text{a}} {\text{²)/2ε}·(N}}_{\text{D}} {\text{- N}}_{\text{DA}} \text{)}$
When a decrease amount of the carrier concentration due to radiation exposure is represented by ΔN_{D},${\text{ΔV}}_{\text{th}} {\text{= {(q·t}}_{\text{a}} {\text{²)/2ε}·ΔN}}_{\text{D}}$

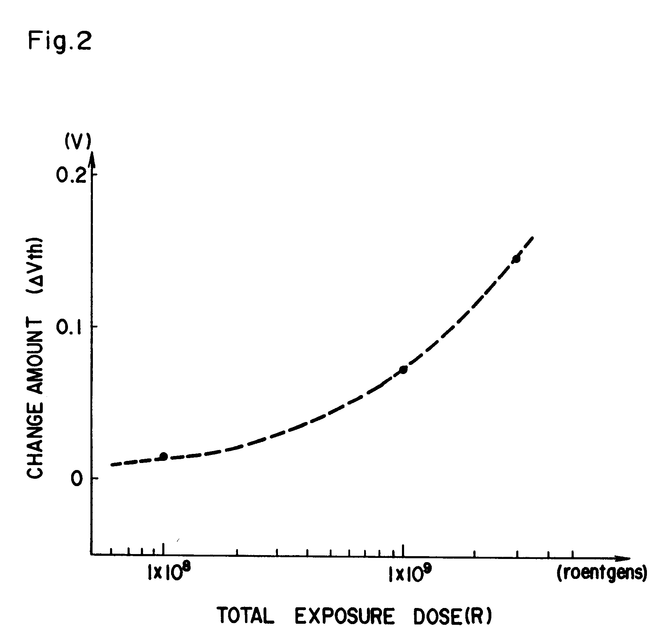

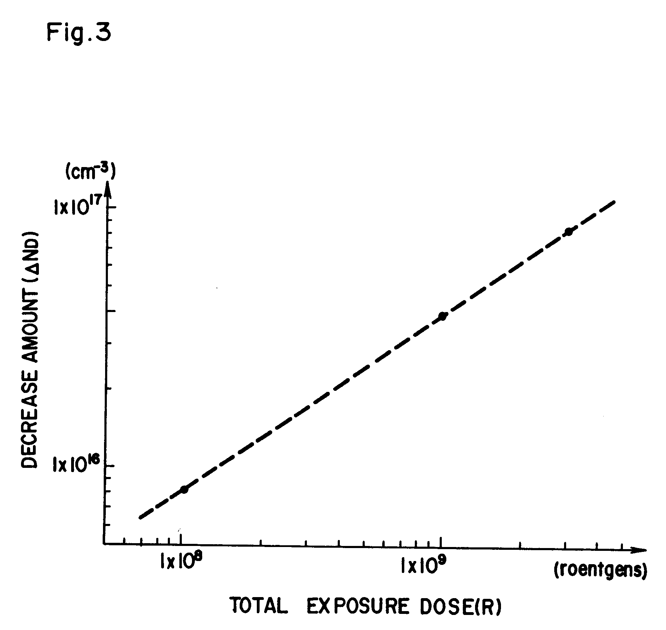

The inventors further studied the change amount ΔVₜₕ of the threshold voltage Vₜₕ by irradiating gamma rays in total exposure doses R=1×10⁸ roentgens, 1×10⁹ roentgens and 3×10⁹ roentgens to a MESFET of Fig. 1 having the active layer 2 of a thickness of 500 Å. The result is shown in Fig. 2 by black points. Based on the results in Fig. 2, using Formula 5, change amounts (decrease amounts) ΔN_{D} of the carrier concentration are indicated by the black points for total doses of R=1×10⁸ roentgens, 1×10⁹ roentgens, and 3×10⁹ roentgens in Fig. 3, which shows that the above described formula${\text{ΔN}}_{\text{D}} {\text{= 3.06 × 10¹⁰ · R}}^{\text{0.678}}$
(the dot line of Fig. 3) holds. When Formula 1 is applied to Fig.2, the dot line in Fig. 2 is obtained. This shows that the experimental result and the theoretical values well agree. In Fig. 2, with a total dose of R=1×10⁹ roentgens, a change amount ΔVₜₕ of the threshold voltage is as low as about 0.075V. Therefore, it is confirmed that the radiation hardness is conspicuously improved when the active layer 2 has a thickness of about 500 Å.

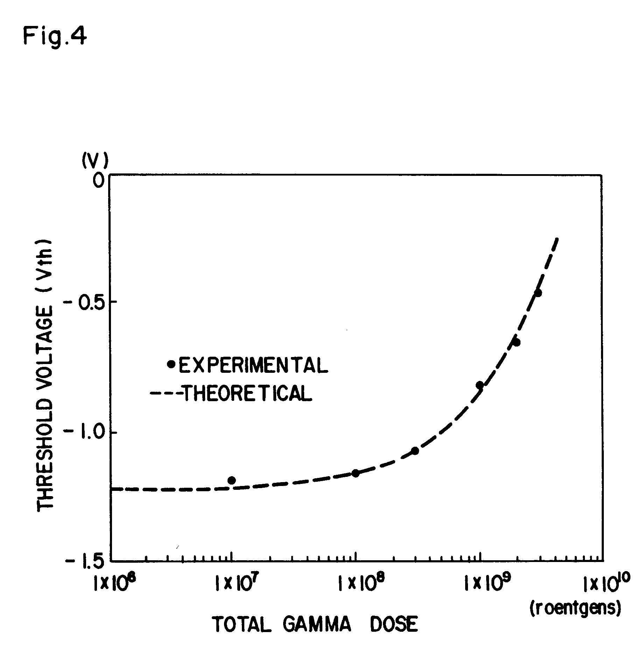

Formula 1 described above was derived from actually measured values for three total doses of R=1×10⁸ roentgens, 1x10⁹ roentgens and 3×10⁹ roentgens. It can be said that these values are insufficient data to derive a general formula. Then the inventors conducted a further experiment of irradiating gamma rays from cobalt 60 to a conventional GaAs MESFET having the same geometrical structure as the GaAs MESFET according to this embodiment, having the active layer 2 in an effective thickness tₐ of 1130 Å so that the carrier concentration N_{D} is 2.09×10¹⁷cm⁻³. In this experiment, total doses were R=1×10⁶ roentgens, 1×10⁷ roentgens, 1×10⁸ roentgens, 3×10⁸ roentgens, 1×10⁹ roentgens, 2×10⁹ roentgens and 3×10⁹ roentgens. The resultant change amounts ΔVₜₕ of the threshold voltage are shown in Fig. 4 by the black points. These points well agree with the theoretical values indicated by the dot line. The change amounts ΔVₜₕ after a radiation exposure of R=1×10⁹ roentgens, however, was about 0.4V, which was remarkably inferior to that in Fig.2.

The results of these experiments on the threshold voltage show the following. Firstly, a major cause for the degradation of the threshold voltage of the MESFET due to radiation damage is a decrease in the carrier concentration of the active layer, and it was found that Formula 1 well expresses a decrease in the carrier concentration under the radiation exposure. Secondly, it has found that the change amount ΔVₜₕ of the threshold voltage Vₜₕ can be set at a required value by setting only the thickness tₐ of the active layer. Specifically, as shown in Fig. 4, when the thickness tₐ of the active layer 2 is set at about 1000 Å as in the conventional MESFETs, the radiation hardness is insufficient, but as shown in Fig. 2, when the thickness tₐ is set at 500 Å, the radiation hardness is conspicuously improved.

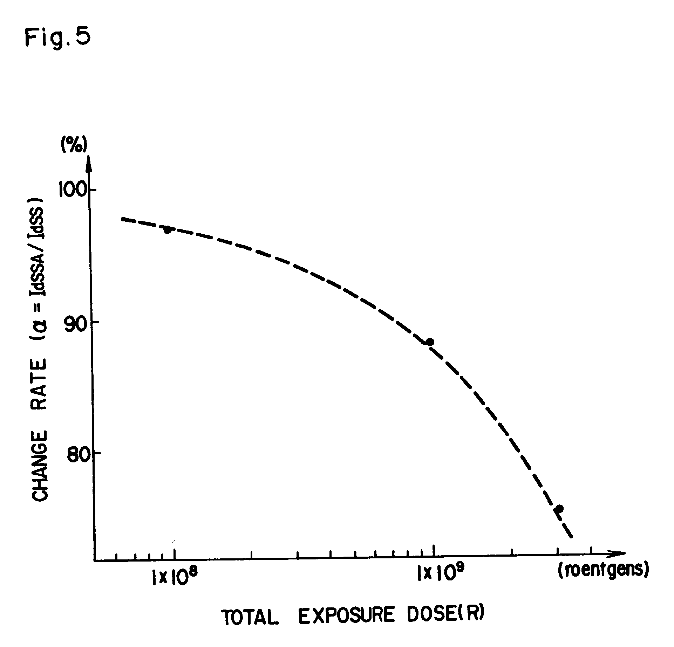

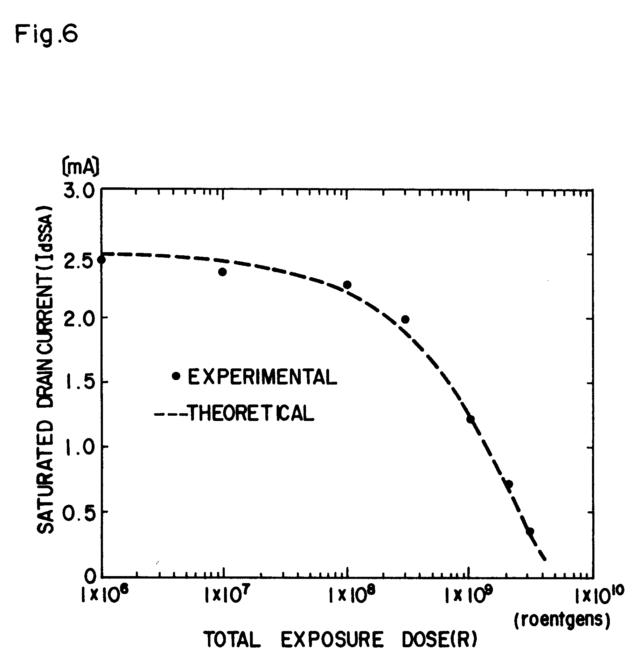

Then, the inventors actually measured changes of the saturated drain current I_{dss} due to the radiation exposure of the same GaAs MESFETs as those which exhibited the threshold voltages Vₜₕ of Figs. 2 and 4. As a result, the characteristic of the change rate α of the saturated drain current I_{dss} of Fig. 5 was obtained in use of same MESFET of Fig. 2.
The saturated drain current I_{dss} of Fig. 6 was obtained in use of same MESFET of Fig. 4. In Figs. 5 and 6, the black points indicate the experimental values, and the dot lines indicate the theoretical values given by applying Formula 10 described below to Formula 1.

The theoretical formula for the change rate α=I_{dssA} /I_{dss} of the saturated drain current I_{dss} will be derived below. The saturated drain current I_{dss} of the MESFET is given for an intrinsic FET with a source resistance Rₛ kept out of consideration, by${\text{I}}_{\text{dss}} {\text{= {(W}}_{\text{g}} {\text{·µ·q²·N}}_{\text{D}} {\text{²·t}}_{\text{a}} {\text{³)/(6ε·L}}_{\text{g}} \text{)}} {\text{× {1-3(V}}_{\text{bi}} {\text{- V}}_{\text{G}} {\text{)/V}}_{\text{p}} {\text{+ 2[(V}}_{\text{bi}} {\text{- V}}_{\text{G}} {\text{)/V}}_{\text{p}} {\text{]}}^{\text{3/2}} \text{}}$
where W_{g} represents a gate width; µ, an electron mobility in the active layer 2; L_{g}, a gate length; V_{G}, a gate voltage; and Vₚ, a pinch-off voltage. When a saturated drain current I_{dss} for V_{G} =V_{bi} is represented by I_{DSS} for simplifying the computation, Formula 6 is rewritten into${\text{I}}_{\text{DSS}} {\text{= (W}}_{\text{g}} {\text{·µ·q²·N}}_{\text{D}} {\text{²·t}}_{\text{a}} {\text{³)/(6ε·L}}_{\text{g}} \text{)}$
when a saturated drain current after the radiation exposure is represented by I_{DSSA}, a change rate α due to the radiation exposure is given based on Formula 7 by${\text{α = I}}_{\text{DSSA}} {\text{/ I}}_{\text{DSS}} {\text{= (µ}}_{\text{A}} {\text{·N}}_{\text{DA}} {\text{²) / (µ·N}}_{\text{D}} \text{²)}$
where N_{DA} is a carrier concentration after the radiation exposure and is given by${\text{N}}_{\text{DA}} {\text{= N}}_{\text{D}} {\text{- ΔN}}_{\text{D}}$
Then Formula 8 is substituted by Formula 9 into${\text{α = {µ}}_{\text{A}} {\text{(N}}_{\text{D}} {\text{- ΔN}}_{\text{D}} {\text{)²}/(µ·N}}_{\text{D}} \text{²)}$

Then Formula 10 will be discussed below. It is found that the change rate α is influenced by changes (µ → µ_{A}) of the electron mobility µ due to the radiation exposure. But µ_{A}/µ is around 0.95 - 0.98 when the carrier concentration before the radiation exposure is about 1×10¹⁸cm⁻³. The change becomes smaller as the carrier concentration becomes higher. Then the computation was made with µ_{A}/µ=0.95. The results were the dot lines of Figs. 5 and 6. As described above, it was confirmed that the results agreed with the experimental values.

These experiments on the saturated drain current I_{dss} and the studies of their results show the following. Firstly, a major cause for the degradation of the I_{dss} of the MESFET as total dose radiation effects is decreases of the carrier concentration of the active layer, and it was found that Formula 1 is very explanatory of the decrease of the carrier concentration due to the radiation exposure. Secondly, the change rate α of the saturated drain current can be set at a required value by setting only the initial carrier concentration (before the radiation exposure) of the active layer, because µ is a constant in Formula 10, the value of µ_{A}/µ can be approximated, and ΔN_{D} can be determined depending on a total radiation dose in Formula 1. Specifically, when the carrier concentration N_{D} of the active layer 2 is set at about 2×10¹⁷cm⁻³ as in the conventional ones, the radiation hardness is insufficient as seen in Fig. 6. When the carrier concentration N_{D} is set at 1×10¹⁸cm⁻³, the radiation hardness is outstandingly improved as seen in Fig. 5.

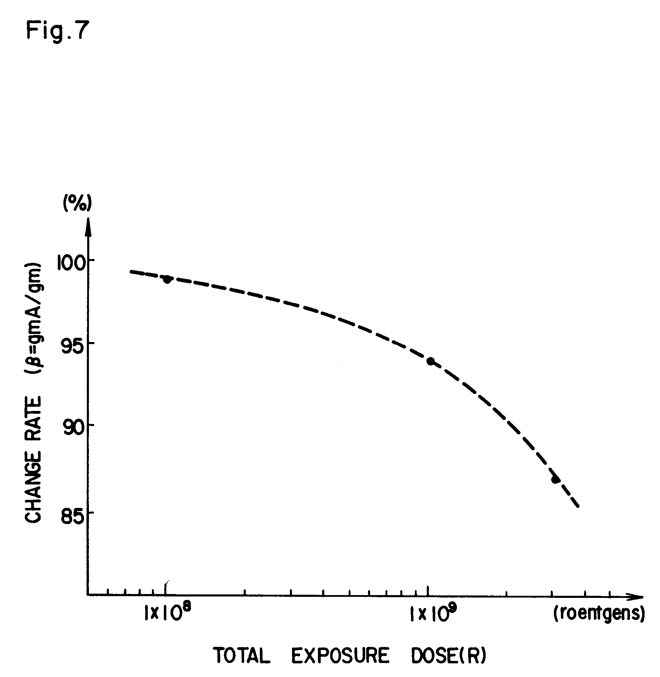

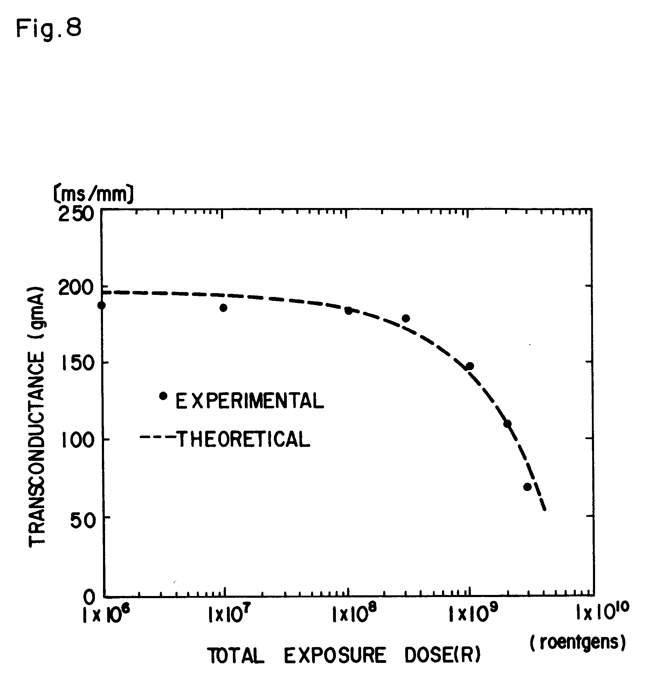

Then, the inventors actually measured changes of the transconductances gₘ due to the radiation exposure in the saturation regions of the same GaAs MESFETs as those which exhibited the threshold voltages Vₜₕ of Figs. 2 and 4 and the saturated drain current I_{dss} characteristics of Figs. 5 and 6. As results, the change rate β of the transconductance gₘ of Fig. 7 was obtained in use of same MESFET of Fig. 2 and 5, and the transconductance gₘ of Fig. 8 was obtained in use of same MESFET of Fig. 4 and 6. In Figs. 7 and 8, the black points indicate the experimental values, and the dot lines indicate the theoretical values given by applying Formula 15 described below to Formula 1.

The theoretical formula for the change rate β=g_{mA}/gₘ of the transconductance will be derived below. A transconductance gₘ in the saturation region of the MESFET is given for an intrinsic FET with a source resistance Rₛ kept out of consideration, by${\text{g}}_{\text{m}} {\text{= {(W}}_{\text{g}} {\text{·µ·q·N}}_{\text{D}} {\text{·t}}_{\text{a}} {\text{)/L}}_{\text{g}} {\text{× {1 -[(V}}_{\text{bi}} {\text{- V}}_{\text{G}} {\text{) / V}}_{\text{p}} {\text{]}}^{\text{1/2}}$
When a transconductance gₘ for V_{G} =V_{bi} is represented by gₘₘₐₓ for simplifying the computation, Formula 11 is rewritten into${\text{g}}_{\text{mmax}} {\text{= (W}}_{\text{g}} {\text{·µ·q·N}}_{\text{D}} {\text{·t}}_{\text{a}} {\text{)/L}}_{\text{g}}$

A change rate β due to the radiation exposure is given based on Formula 12 by${\text{β = g}}_{\text{mmaxA}} {\text{/ g}}_{\text{mmax}} {\text{= (µ}}_{\text{A}} {\text{·N}}_{\text{DA}} {\text{) / (µ·N}}_{\text{D}} \text{)}$
where N_{DA} is a carrier concentration after the radiation exposure and given by${\text{N}}_{\text{DA}} {\text{= N}}_{\text{D}} {\text{- ΔN}}_{\text{D}}$
Then Formula 13 is substituted by Formula 14 into${\text{β = {µ}}_{\text{A}} {\text{(N}}_{\text{D}} {\text{- ΔN}}_{\text{D}} {\text{)}/(µ·N}}_{\text{D}} \text{)}$

Then Formula 15 will be discussed below. It is found that the change rate β is influenced by changes (µ → µ_{A}) of the electron mobility µ due to the radiation exposure. But µ_{A}/µ is around 0.95 when the carrier concentration before the radiation exposure is about 1×10¹⁸cm⁻³. The change becomes smaller as the carrier concentration becomes higher. Then the computation was made with µ_{A}/µ=0.95. The results were the dot lines of Figs. 7 and 8. As described above, it was confirmed that the results agreed with the experimental values.

These experiments and the studies of their results show the following. Firstly, a major cause for the degradation of the transconductance of the MESFET as total dose radiation effect is a decrease of the carrier concentration in the active layer, and it was found that Formula 1 is very explanatory of the decrease of the carrier concentration due to the radiation exposure. Secondly, the change rate β of the transconductance can be set at a required value by setting only the initial carrier concentration of the active layer, because µ is a constant in Formula 15, the value of µ_{A}/µ can be approximated, and ΔN_{D} is determined based on Formula 1, depending on a radiation dose. Specifically, when the carrier concentration N_{D} of the active layer 2 is set at about 2×10¹⁷cm⁻³ as in the conventional ones, the radiation hardness is insufficient as seen in Fig. 8. When the carrier concentration N_{D} is set at 1×10¹⁸cm⁻³, the radiation hardness is outstandingly improved as seen in Fig. 7.

It is possible that, based on the above described findings, a structure of a semiconductor device which is able to operate normally under the radiation exposure of a total dose R not only below 1×10⁹ roentgens but also a total dose R above 1×10⁹ roentgens can be specified based on a thickness tₐ of the active layer 2 and a carrier concentration N_{D}. That is, in order that a GaAs MESFET and a signal processing circuit are combined into such semiconductor device, and the signal processing circuit can operate as designed when a tolerable change amount of the threshold voltage Vₜₕ of the MESFET is V_{thL}, an effective thickness tₐ of the active layer 2 must be${\text{t}}_{\text{a}} {\text{< {(2ε·ΔV}}_{\text{thL}} {\text{)/(q·ΔN}}_{\text{D}} {\text{)}}}^{\text{1/2}}$
based on Formula 5. In this case, the carrier concentration N_{D} of the active layer 2 is given as follows based on Formula 2 by${\text{N}}_{\text{D}} {\text{= {[2ε/(q·t}}_{\text{a}} {\text{²)]·(V}}_{\text{bi}} {\text{- V}}_{\text{th}} \text{)}}$
Here, when a tolerable change amount ΔV_{thL} of the threshold voltage Vₜₕ for a total exposure dose of R=1×10⁹ roentgens is specifically computed by${\text{ΔV}}_{\text{thL}} {\text{= 0.1V(ΔV}}_{\text{th}} \text{< 0.1V),}$
a change amount ΔN_{D} of the carrier concentration is given by${\text{ΔN}}_{\text{D}} \text{= 3.87 × 10¹⁶cm⁻³.}$
An effective thickness tₐ of the active layer 2 is given below 585 Å (500 Å for the MESFET of Fig. 2), based on Formula 16. Further, with a thickness of the active layer 2 set at below 585 Å, when the threshold voltage Vₜₕ is given${\text{V}}_{\text{th}} \text{= -1.2V,}$
a carrier concentration N_{D} of the active layer 2 is given 7.353×10¹⁷cm⁻³ by Formula 17, where
a dielectric constant of the active layer${\text{ε = ε}}_{\text{s}} \text{·ε₀} \text{= 12.0 × 8.85 × 10⁻¹²F/m}$
an electron charge$\text{q = 1.602 × 10⁻¹⁹C, and}$
a built-in voltage V_{bi} = 0.7V.

In order that the combination circuit related to the semiconductor device operates as required when a tolerable change rate of the saturated drain current I_{dss} of the MESFET is represented by α_{L}, an initial carrier concentration N_{D} of the active layer 2 must be, based on Formula 10 by${\text{N}}_{\text{D}} {\text{> ΔN}}_{\text{D}} {\text{/{1-[α}}_{\text{L}} {\text{(µ/µ}}_{\text{A}} {\text{)]}}^{\text{1/2}} \text{}}$
In this case, an effective thickness tₐ of the active layer 2 is given by${\text{t}}_{\text{a}} {\text{={[2ε/(q·N}}_{\text{D}} {\text{)](V}}_{\text{bi}} {\text{-V}}_{\text{th}} \text{)}}$
Here, for a total exposure dose of R=1×10⁹ roentgens, with α_{L} (a tolerable change rate of the saturated drain current I_{DSS})=0.9 (I_{DSSA}>0.9I_{DSS}), a change amount ΔN_{D} of the carrier concentration is given based on Formula 1 by${\text{ΔN}}_{\text{D}} \text{= 3.87 × 10¹⁶cm⁻³,}$
and the carrier concentration of the active layer 2 becomes above 1.45×10¹⁸cm⁻³ based on Formula 10. With this carrier concentration, when the threshold voltage Vₜₕ is given${\text{V}}_{\text{th}} \text{= -1.2V.}$
the effective thickness of the active layer 2 is given 416 Å based on Formula 19.

Further, in order that the GaAs MESFET and a signal processing circuit are combined into this semiconductor device, and the signal processing circuit can operate as designed when a tolerable change rate of the transconductance gₘ in the saturation region of the MESFET is β_{L}, an initial carrier concentration N_{D} of the active layer 2 must be, based on Formula 15,${\text{N}}_{\text{D}} {\text{> ΔN}}_{\text{D}} {\text{/{1 - β}}_{\text{L}} {\text{(µ/µ}}_{\text{A}} \text{)}}$
In this case, an effective thickness tₐ of the active layer 2 must be${\text{t}}_{\text{a}} {\text{= {[ε/(q·N}}_{\text{D}} {\text{)}] (V}}_{\text{bi}} {\text{-V}}_{\text{th}} {\text{)}}}^{\text{1/2}}$
Here, for a total exposure dose of R=1×10⁹ roentgens, with β_{L} (a tolerable change rate of the transconductance gₘₘₐₓ) = 0.9 (g_{mmaxA} >0.9 gₘₘₐₓ), a change amount ΔN_{D} is given by${\text{ΔN}}_{\text{D}} \text{= 3.87 × 10¹⁶cm⁻³}$
based on Formula 1. The carrier concentration of the active layer 2 is given above 7.35×10¹⁷cm⁻³ by Formula 15. With the carrier concentration of the active layer 2 above this value and with the threshold voltage Vₜₕ given${\text{V}}_{\text{th}} \text{= -1.2V,}$
an effective thickness tₐ of the active layer 2 is given 585 Å by Formula 22.

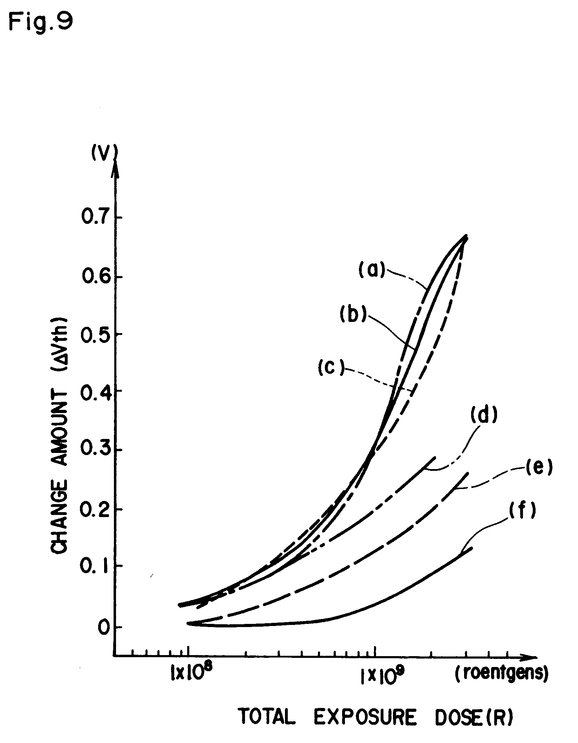

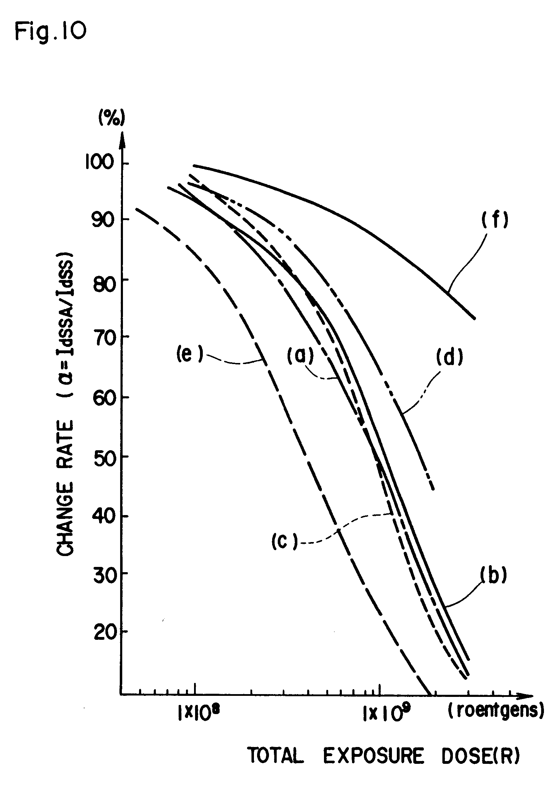

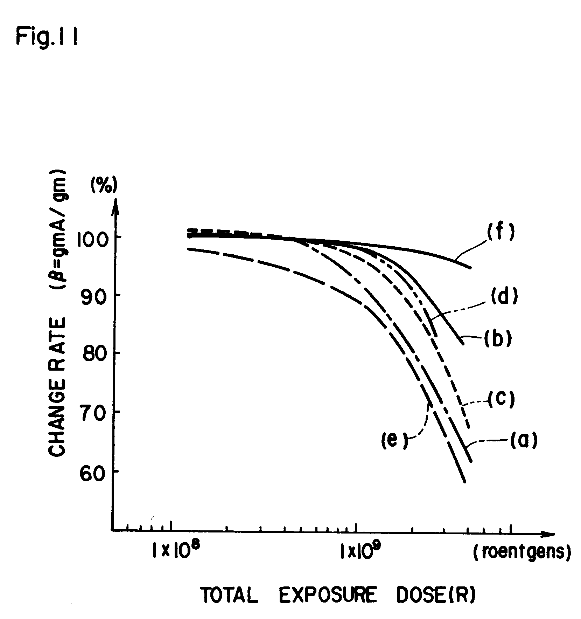

The semiconductor device according to this invention and the conventional ones will be compared in radiation hardness in Fig . 9 to 11. Fig. 9 shows change amounts ΔVₜₕ of the threshold voltage Vₜₕ due to the radiation exposure. Fig. 10 shows change rates α of the saturated drain current I_{dss}. Fig. 11 shows change rates β of the transconductance gₘ. In Figs. 9 - 11, curves (a), (b) and (c) show characteristics of the conventional commercial MESFETs. The curve (b) corresponds to the characteristics of Figs. 4, 6 and 8 for the active layer 2 of a 1130 Å effective thickness tₐ and a carrier concentration of 2.09×10¹⁷cm⁻³. The curve (d) shows the characteristics of a conventional HEMT (high electron mobility transistor). As evident from Fig. 9, these conventional semiconductor devices have change amounts ΔVₜₕ of the threshold voltage as high as 0.2 to 0.3V for a total dose of R=1×10⁹ roentgens. The curve (e) in Fig. 9 shows the characteristic of a MESFET having a p-type layer buried below an n-type active layer for decreasing leakage current to the substrate, and the change amount ΔVₜₕ is suppressed to about 0.12V for R=1×10⁹ roentgens. In contrast to this, in the MESFET according to this invention having the active layer 2 of an effective thickness tₐ of 500 Å (corresponding to the characteristic of Fig. 2), the change amount ΔVₜₕ is suppressed to a value lower than 0.1V even for R=1×10⁹ roentgens as indicated by the curve (f), and it is found that the radiation hardness is much improved. It is evident from Figs. 10 and 11 that such improvement in the radiation hardness is also exhibited in the saturated drain current I_{dss} and the transconductance gₘ.

In this invention, even under the radiation exposure of a total exposure dose equal to or higher than R=1×10⁸ roentgens, the values of the threshold voltage Vₜₕ, saturated drain current I_{dss} and transconductance gₘ remain within their tolerable ranges. A GaAs MESFET which is acknowledged as superior in radiation hardness characteristic must have radiation hardness to a total exposure dose of about 1.4×10⁸ ∼ 4.3×10⁹ roentgens. For this exposure dose, the absorbed dose of GaAs is totally 1×10⁸ ∼ 3×10⁹ rad. (1 roentgen = 0.7 rads. in GaAs). On the other hand, the tolerable range of the change (positive shift) amount ΔVₜₕ of the threshold voltage Vₜₕ is 0.2 V, and the tolerable ranges of the change rates α=I_{dss}/I_{dss}, β=g_{mA}/gₘ of the saturated drain current I_{dss} and the transconductance gₘ are about 80%. Specifically, when the change amount ΔVₜₕ = 0.15V with a total exposure dose R=1.5×10⁹ roentgens, it can be said that the GaAs MESFET has superior radiation hardness.

But what has to be noted here is that the above described tolerable change amount ΔV_{thL}, and the tolerable change rates α_{L}, β_{L} greatly vary depending on circuits combined with the GaAs MESFET. Specifically, one example is SCFL (Source coupled FET Logic) circuits which have low integrity but have enabled high speed operation. In theses circuits, the operation speed is substantially determined by a current flowing through two transistors in the buffer stages. Accordingly, when values of the Vₜₕ, I_{dss} and gₘ vary due to a radiation exposure, the operation speed greatly varies. But the influence on the operation speed by the changes of values of Vₜₕ, I_{dss} and gₘ can be reduced by 1/3 ∼ 1/4 by setting the values of resistors of the SCFL circuit at suitable values. Consequently, even in a SCFL circuit which allows for a change of the operation speed of only 10%, the tolerable change is 200 m/V for the threshold voltage Vₜₕ (V_{thL}=0.2V), and the tolerable changes for the saturated drain current I_{dss} and the transconductance gₘ are about 20% (α_{L}=0.8, β_{L}=0.8).

By contrast, another example is a memory cell for a memory IC which have integrity on a semiconductor chip, the tolerable range for those changes are narrowed. Specifically, in this IC, a time in which one small memory cell charges and discharges the data lines occupies a large part of a total access time. Furthermore, each memory cell has the transistors, resistors, etc. miniaturized for reducing power consumption. Consequently, the operation speed greatly varies depending on changes of the parameters. Specifically, in order to keep the change of the memory access time within 20%, the tolerable change amount of the threshold voltage Vₜₕ is only 50 mV (ΔV_{thL} = 0.05V), and the tolerable change rates of the saturated drain current I_{dss} and the transconductance gₘ are only 10% (α_{L}=0.9, β_{L}=0.9).

This invention is not limited to the above described embodiment and covers various modifications.

For example, the active layer is not necessarily formed by the epitaxial growth but may be formed by the ion implantation. The recess structure of Fig. 1 is not essential.

## Claims

1. A radiation resistive semiconductor device comprising a signal processing circuit combined with a MESFET having a semi-insulating GaAs substrate (1) with an active layer (2) doped substantially evenly depthwise with a carrier concentration N_{D} and directly formed on said substrate (1), and a gate electrode (6) formed on said active layer (2), said MESFET having a threshold voltage Vₜₕ with a change amount ΔVₜₕ, a saturated drain current I_{dss} with a change rate α and a transconductance gₘ with a change rate β, these parameters being changed upon exposure of the device to a radiation exposure of a total dose R equal to or higher than 1 x 10⁹ roentgens within admissible change amounts ΔV_{thL} and α_{L} and β_{L}, respectively, wherein ΔV_{thL} ≦ 0.2 V, α_{L} and β_{L} ≧ 0.8,
the effective thickness tₐ of the active layer (2) being given by${\text{t}}_{\text{a}} {\text{< {(2ε·ΔV}}_{\text{thL}} {\text{) / (q·ΔN}}_{\text{D}} {\text{)}}}^{\text{1/2}} \text{and}$ the carrier concentration N_{D} of the active layer (2) before the radiation exposure being given by${\text{N}}_{\text{D}} {\text{> ΔN}}_{\text{D}} {\text{/ {1 - [α}}_{\text{L}} {\text{(µ/µ}}_{\text{A}} {\text{)]}}^{\text{1/2}} \text{} and/or}$${\text{N}}_{\text{D}} {\text{> ΔN}}_{\text{D}} {\text{/ {1 - β}}_{\text{L}} {\text{(µ/µ}}_{\text{A}} \text{)},}$ where µ and µ_{A} represent the carrier mobilities in the active layer (2) respectively before and after the radiation exposure, ΔN_{D} the decrease of carrier concentration due to the radiation exposure, ε the dielectric constant of the active layer (2), and q the electron charge.

2. A semiconductor device according to claim 1, wherein a decrease amount ΔN_{D} of the carrier concentration is given by${\text{ΔN}}_{\text{D}} {\text{= b · R}}^{\text{c}}$ where b and c are constants.

3. A semiconductor device according to claim 2, wherein the constants b and c are$\text{1.99 x 10¹⁰ ≦ b ≦ 3.98 x 10¹⁰}$$\text{0.5 ≦ c ≦ 0.8.}$

## Patentansprüche

1. Eine strahlungsbeständige Halbleitervorrichtung mit einer Signalverarbeitungsschaltung, die mit einem MESFET kombiniert ist, der ein halbisolierendes GaAs-Substrat (1) mit einer aktiven Schicht (2), die im wesentlichen tiefenmäßig gleichmäßig mit einer Ladungsträgerkonzentration N_{D} dotiert und direkt auf dem Substrat (1) ausgebildet ist, und eine auf der aktiven Schicht (2) ausgebildete Gateelektrode (6) aufweist, wobei der MESFET eine Schwellenspannung Vₜₕ mit einem Änderungsbetrag ΔVₜₕ, einen gesättigten Drainstrom I_{dss} mit einer Änderungsrate α und eine Vorwärtssteilheit gₘ mit einer Änderungsrate β aufweist, wobei diese Parameter, nachdem die Vorrichtung einer Strahlenbelastung mit einer Gesamtdosis R von 1 x 10⁹ Röntgen oder mehr ausgesetzt wurde, innerhalb zulässiger Änderungsbeträge ΔV_{thL} bzw. α_{L} bzw. β_{L} geändert sind, wobei ΔV_{thL} ≦ 0,2V, α_{L} und β_{L} ≧ 0,8 sind,
die wirksame Dicke tₐ der aktiven Schicht (2) durch${\text{t}}_{\text{a}} {\text{< {(2ε · ΔV}}_{\text{thL}} {\text{) / ( q · ΔN}}_{\text{D}} {\text{)}}}^{\text{1/2}} \text{und}$ die Ladungsträgerkonzentration N_{D} der aktiven Schicht (2) vor der Strahlenbelastung durch${\text{N}}_{\text{D}} {\text{> ΔN}}_{\text{D}} {\text{/ {1 - [α}}_{\text{L}} {\text{(µ/µ}}_{\text{A}} {\text{)]}}^{\text{1/2}} \text{} und/oder}$${\text{N}}_{\text{D}} {\text{> ΔN}}_{\text{D}} {\text{/ {1 - β}}_{\text{L}} {\text{(µ/µ}}_{\text{A}} \text{)}}$ gegeben ist, wobei µ und µ_{A} die Ladungsträgerbeweglichkeiten in der aktiven Schicht (2) entsprechend vor und nach der Strahlenbelastung, ΔN_{D} die Abnahme der Ladungsträgerkonzentration aufgrund der Strahlenbelastung, ε die dielektrische Konstante der aktiven Schicht (2) und q die Elektronenladung darstellen.

2. Eine Halbleitervorrichtung nach Anspruch 1, wobei ein Abnahmebetrag ΔN_{D} der Ladungsträgerkonzentration durch${\text{ΔN}}_{\text{D}} {\text{= b · R}}^{\text{c}}$ bestimmt ist, wobei b und c Konstanten sind.

3. Eine Halbleitervorrichtung nach Anspruch 2, wobei für die Konstanten b und c$\text{1,99 × 10¹⁰ ≦ b ≦ 3,98 × 10¹⁰ bzw.}$$\text{0,5 ≦ c ≦ 0,8}$ gilt.

## Revendications

1. Dispositif à semi-conducteur résistant aux radiations comprenant un circuit de traitement du signal combiné avec un transistor à effet de champ métal-semi-conducteur comportant un substrat GaAs semi-isolant (1) avec une couche active (2) dopée quasiment uniformément en profondeur avec une concentration de porteurs N_{D} et directement formée sur ledit substrat (1) et une électrode de grille (6) formée sur ladite couche active (2), ledit transistor à effet de champ métal-semi-conducteur comportant une tension de seuil Vₜₕ avec une quantité de variation ΔVₜₕ, un courant de drain saturé I_{dss} avec un taux de variation α et une transconductance gₘ avec un taux de variation β, ces paramètres étant modifiés par l'exposition du dispositif à une exposition aux radiations d'une dose totale R égale à ou supérieure à 1x10⁹ roentgens à l'intérieur des quantités de variation admissibles ΔV_{thL} et α_{L} et β_{L}, respectivement, dans lequel ΔV_{thL} ≦ 0,2 V, α_{L} et β_{L} ≧ 0,8,
l'épaisseur efficace tₐ de la couche active (2) étant donnée par${\text{t}}_{\text{a}} {\text{< {(2ε·ΔV}}_{\text{thL}} {\text{) / (q·ΔN}}_{\text{D}} {\text{)}}}^{\text{1/2}} \text{et}$ la concentration de porteurs N_{D} de la couche active (2) avant l'exposition aux radiations étant donné par${\text{N}}_{\text{D}} {\text{> ΔN}}_{\text{D}} {\text{/{1-[ α}}_{\text{L}} {\text{(µ/µ}}_{\text{A}} {\text{)]}}^{\text{1/2}} \text{} et/ou}$${\text{N}}_{\text{D}} {\text{> ΔN}}_{\text{D}} {\text{/{1- β}}_{\text{L}} {\text{(µ/µ}}_{\text{A}} \text{)},}$ où µ et µ_{A} représentent les mobilités de porteurs dans la couche active (2) respectivement avant et après l'exposition aux radiations, ΔN_{D} la diminution de la concentration de porteurs du fait de l'exposition aux radiations, ε la constante diélectrique de la couche active (2) et q la charge de l'électron.

2. Dispositif à semi-conducteur selon la revendication 1, dans lequel une quantité de diminution ΔN_{D} de la concentration de porteurs est donnée par${\text{ΔN}}_{\text{D}} {\text{= b · R}}^{\text{c}}$ où b et c sont des constantes.

3. Dispositif à semi-conducteur selon la revendication 2, dans lequel les constantes b et c sont$\text{1,99 x 10¹⁰ ≦ b ≦ 3,98 x 10¹⁰}$$\text{0,5 ≦ c ≦ 0,8.}$
